# EUROPEAN PATENT SPECIFICATION

(11) **EP 0 390 971 B1**
(45) Date of publication and mention of the grant of the patent: **13.03.1996**
(21) Application number: 89122911.4
(22) Date of filing: 12.12.1989
(51) Int. Cl.: H03H 7/06, H03G 5/16

(54) **Acoustic characteristic correction circuit in high fidelity amplifier**
Schaltung in einem Hifi-Verstärker zur Korrektur von akustischen Merkmalen
Circuit, dans un amplificateur haute fidélité, de correction de la caractéristique acoustique

(30) Priority: 03.04.1989 JP 84588/89
(43) Date of publication of application: 10.10.1990
(73) Proprietor: Ohkuma, Saburoh, Hachioji-shi Tokyo (JP)
(72) Inventor: Ohkuma, Saburoh, Hachioji-shi Tokyo (JP)
(74) Representative: Kraus, Walter, Dr.

(56) References cited:
- JP-A- 2 108 312
- JP-A- 2 108 313
- JP-A-63 314 905
- ELECTROTECHNOLOGY. vol. 75, no. 1, January 1965, BEVERLY SHORES US pages 26 -
- 36; A. W. Langill: "Designing passive compensators"
- Don & Carolyn Davis: "Sound System Engineering", Sams, Indianapolis, US, 1979
- Günther Schmidt: "Verhalten typischer Regelkreisglieder", Technical University Munich, DE, 1978

## Description

### BACKGROUND OF THE INVENTION

### 1. Field of the Invention

The present invention relates to an acoustic characteristic correction circuit in a high fidelity regenerative amplifier which corrects the sound quality and the frequency characteristic of regenerated sound so that regenerated sound near to original sound is reproduced in a regenerated sound field and more particularly to an acoustic characteristic correction circuit in a high fidelity regenerative amplifier having an ideal phase characteristic.

### 2. Description of the Prior Art

Recently, an audio amplifier generally used, specifically an audio amplifier provided in an automobile includes an equalizer which corrects an acoustic characteristic peculiar to the interior of a room of an automobile which is a sound field and corrects the sound quality and the frequency characteristic of regenerated sound so that regenerated sound by the amplifier is reproduced in a state near to original sound.

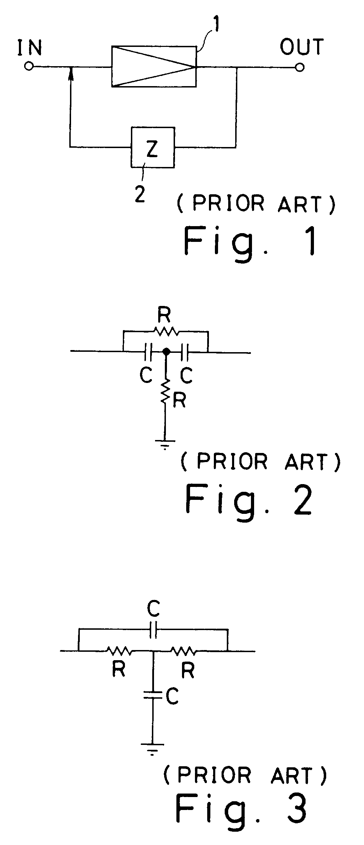

This equalizer generally employs an NFB type having a configuration as shown in Fig. 1.

The equalizer of the NFB type includes an NFB amplifier 1 and a filter circuit 2 of a kind having a selectivity of a frequency and connected to a feedback circuit of the amplifier 1. The filter circuit 2 uses various circuits, for example, composed of resistors R and condensers C as shown in Fig. 2 or 3 by request.

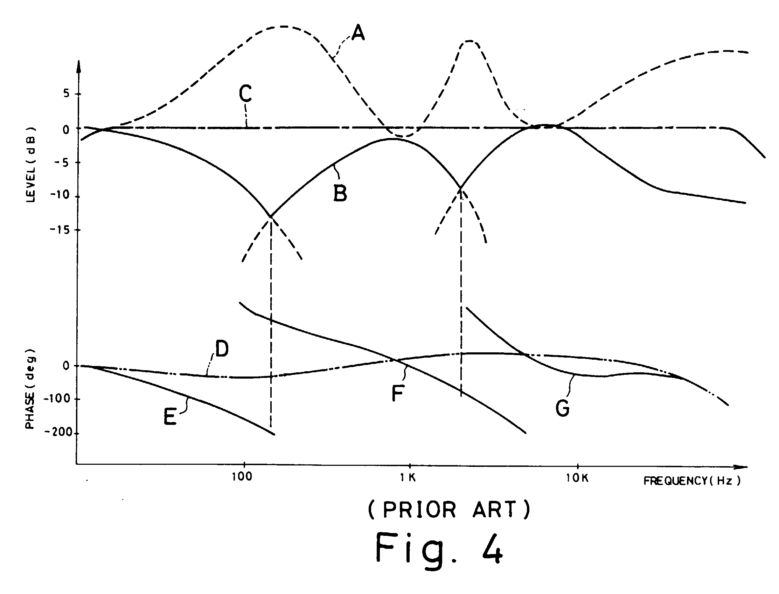

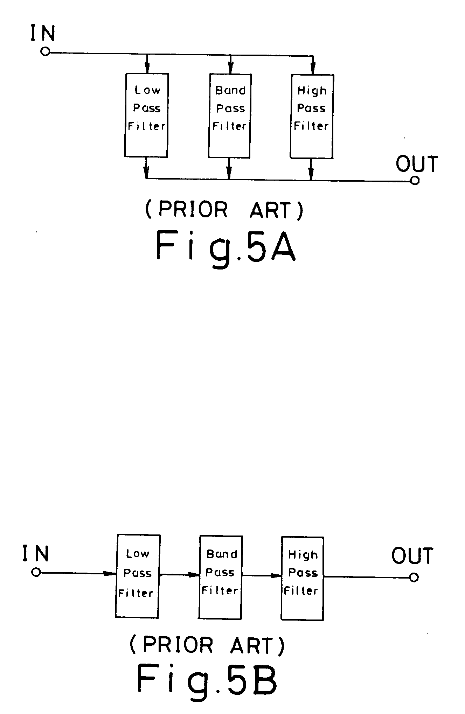

When listening to ideal sound near to original sound in a room (for example, in a room of an automobile) having a frequency characteristic, for example, as shown by a frequency characteristic curve A of Fig. 4, if an amplifier including an equalizer having a characteristic as shown by a frequency characteristic curve B of Fig. 4 by connecting a low pass filter, a band pass filter and a high pass filter each having a configuration as shown in Fig. 1 to each other as shown in Figs. 5A and 5B is used to regenerate sound, a mountain portion of the frequency characteristic of the room is corrected to regenerate sound with substantially flat frequency characteristic over a wide frequency range as shown by the frequency characteristic curve C of Fig. 4 so that regenerated sound near to original sound in the aspect of the frequency characteristic is reproduced. Thus, heretofore, the equalizer capable of correcting the sound flied characteristic in the room of the automobile is provided in the amplifier so that music can be heard in a relatively good state even in the room of the automobile in which the acoustic characteristic is not so good.

A conventional equalizer is known from "Sound System Engineering" by Don & Carolyn Davis, Sams US, page 133 ff.

However, in the conventional equalizer, the frequency characteristic can be made flat by the equalizer, while a phase characteristic is very dissatisfactory.

More particularly, when a single sound of a sine wave is employed and its frequency is gradually increased or decreased so that the phase characteristic of the equalizer is measured by a measuring apparatus, there can be obtained a phase characteristic having no large variation over the substantially all frequency range apparently as shown by the phase characteristic curve D of Fig. 4. However, since the phase characteristic is obtained as a result of a combination of a phase characteristic curve E of a low pass filter, a phase characteristic curve F of a band pass filter and a phase characteristic curve G of a high pass filter, a phase distortion occurs due to a phase difference in a frequency range in which the phase characteristic curves of each of the filters are overlapped to thereby cause deterioration and impurity of the quality of sound and indefiniteness of orientation of the acoustic image. The phase distortion is particularly large at the overlap point of the frequency characteristic curves of the filters, that is, in the vicinity of a dip point. This is caused by the fact that the equalizer includes a feedback circuit.

The quality of sound has been heretofore improved, although the improvement in the prior art resides in the realization of the flat frequency characteristic in the sound field. However, when the higher quality sound is required, the phase characteristic can not be neglected. The phase of regenerated sound is an important improvement item since it is an important element to the orientation of the acoustic image when excellent sound in the psychological aspect which is not measured by any measuring apparatus, directly speaking, natural sound, such as sound having presence or transparency, or sound which does not give fatigue even if listening to the sound for a long time is pursued.

### SUMMARY OF THE INVENTION

The present invention has been made to solve the above problems in the prior art and an object of the present invention is to provide an acoustic characteristic correction circuit in a high fidelity amplifier capable of regenerating natural sound having no phase distortion as it is with a relatively simple circuit.

According to the present invention, the circuit which corrects the sound quality and the frequency characteristic of the regenerative sound so that regenerated sound in various sound fields can be reproduced in a state near to original sound, comprises an acoustic correction circuit as set out in claim 1.

With the acoustic characteristic correction circuit constructed above, the phase distortion can be removed and the front and rear relation of a sound source is clear so that regenerated sound can be brought close to more natural sound as compared with sound regenerated heretofore.

### BRIEF DESCRIPTION OF THE DRAWINGS

Fig. 1 is a schematic block diagram of a filter constituting a conventional equalizer;
Figs. 2 and 3 are actual circuit diagrams of the filter shown in Fig. 1;
Fig. 4 is a characteristic diagram of a conventional equalizer;
Figs. 5A and 5B are schematic block diagrams showing configurations of conventional equalizers;
Fig. 6 is a schematic circuit diagram of an acoustic characteristic correction circuit in a high fidelity amplifier according to the present invention;
Fig. 7 is a schematic circuit diagram showing only one channel of the circuit shown in Fig. 6; and
Fig. 8 is a characteristic diagram of an acoustic characteristic correction circuit in a high fidelity correction amplifier according to the present invention.

### DETAILED DESCRIPTION OF THE INVENTION

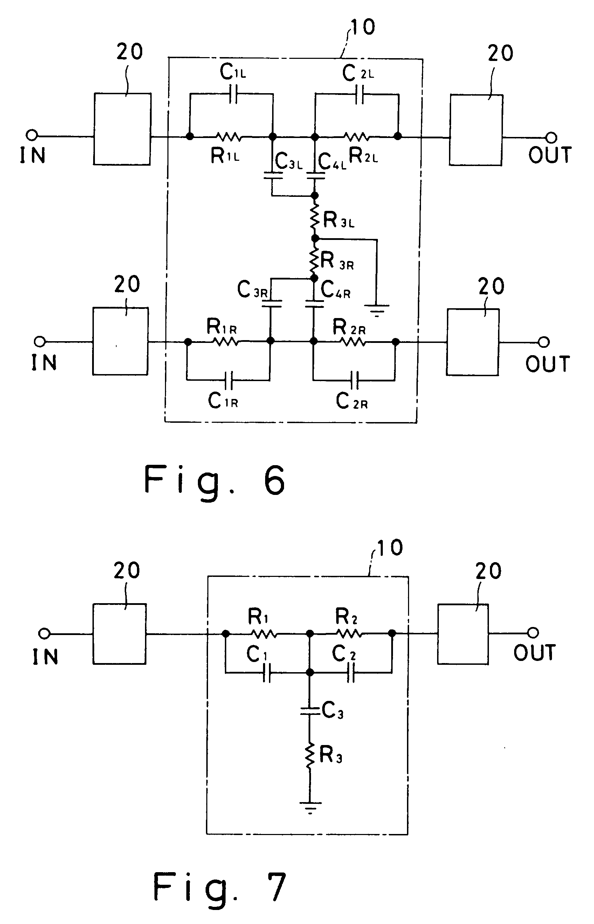

Fig. 6 is a schematic circuit diagram of an acoustic characteristic correction circuit according to the present invention.

This circuit comprises an equalizer 10 and impedance circuits 20 connected in series to the preceding stage and/or the rear stage of the equalizer 10. As shown in the figure, the equalizer 10 comprises resistors and condensers. Parallel circuits of a condenser C_{1L} and a resistor R_{1L}, and a condenser C_{2L} and a resistor R_{2L} constitute a left high pass filter, and parallel circuits of a condenser C_{1R} and a resistor R_{1R}, and a condenser C_{2R} and a resistor R_{2R} constitute a right high pass filter. Further, condensers C_{3L} and C_{4L} and a resistor R_{3L} constitute a left low pass filter, and condensers C_{3R} and C_{4R} and a resistor R_{3R} constitute a right low pass filter. These high pass filters and the low pass filters are connected one another and one end of the low pass filters is connected to ground. Fig. 7 equivalently shows only one side of the circuit of Fig. 6.

In the equalizer 10 implementing the present invention, decision of constants of constituent elements is very important.

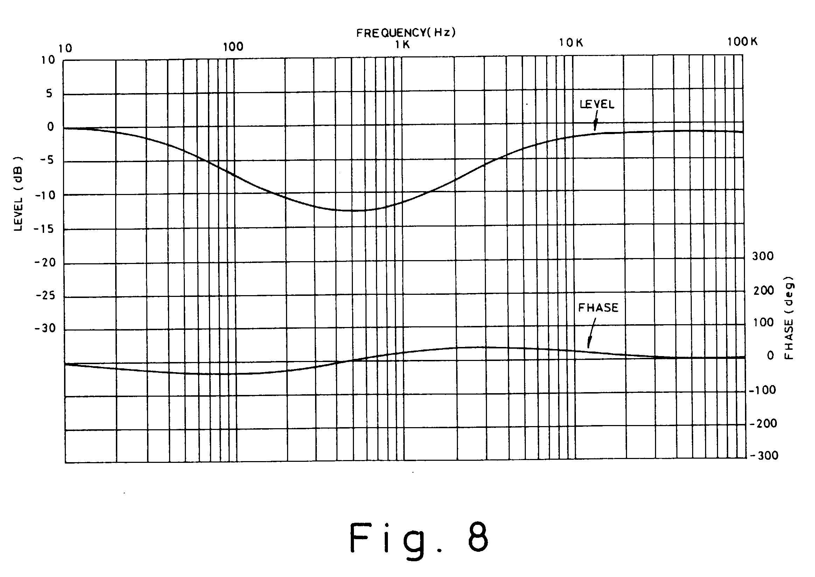

More particularly, it is ideal that the dip point described above is decided to substantially match a resonance frequency of a room or a room of a vehicle which is a sound field. However, since the equalizer 10 of the present embodiment has the phase characteristic and the frequency characteristic which are changed very smoothly, very severe setting is not necessary. The phase characteristic in the frequency range less than the dip point is set to tend to lag and the level in the frequency range less than the dip point is set to be increased as the frequency is decreased. With the setting, the orientation feeling in the right and left direction is improved so that sound is given solemn feeling. In the frequency range larger than the frequency at the dip point and less than 5 KHz, the phase characteristic is set to tend to lead and the level of the frequency characteristic is set to be increased. With the setting, the orientation feeling in the front and rear direction is improved. Since the frequency range from 5 KHz to the vicinity of 12 KHz is a frequency range in which abundance of musicality is affected, the phase characteristic is set to tend to lead and the frequency characteristic is set to be increased in the same manner as above. The frequency range larger than 12 KHz is an important frequency range for improvement of atmosphere and more natural sound and is a frequency range necessary for removing psychological sense of oppression as if a head were suppressed. Further, in the vicinity of the dip point, the characteristic is set to a reverse characteristic to a peak of a resonance frequency of the regenerated sound field, such as, for example a room of a vehicle. Accordingly, it is necessary to set the constants so that the characteristics required for each of the frequency ranges are satisfied. Fig. 8 shows an example of the characteristics, which satisfy the characteristics required for each of the frequency ranges.

The impedance circuits 20 are provided to exhibit the above characteristics of the equalizer 10 sufficiently.

More particularly, the characteristic of the equalizer 10 is shown in Fig. 8, while the equalizer 10 has a delicate relation to an impedance of a circuit connected to an input or an output of the equalizer and the frequency characteristic and the phase characteristic in a low or high frequency range are affected by a value of the impedance. Namely, there is no problem when an output impedance of a preceding circuit (not shown) of the equalizer 10 is low as compared with an input impedance of the equalizer 10, while the level at a low frequency range is not increased sufficiently and at the same time the phase characteristic at a low frequency range is not delayed sufficiently in the characteristic diagram of Fig. 8 when the output impedance of the preceding circuit of the equalizer 10 is high as compared with the input impedance of the equalizer 10. Accordingly, the acoustic characteristic at a low frequency range is not utilized. Further, there is no problem when an input impedance of a rear stage (not shown) of the equalizer 10 is high as compared with an output impedance, while the level at a high frequency range is increased too much and at the same time the phase characteristic at a high frequency range is advanced too much in the characteristic, diagram of Fig. 8 when the input impedance of the rear stage of the equalizer 10 is low as compared with the output impedance of the equalizer 10. Accordingly, in this case, the acoustic characteristic at a high frequency range is not utilized. The impedance conversion circuits 20 function to exhibit the acoustic characteristic of the equalizer 10 at the low and high frequency ranges sufficiently. In the present embodiment, the impedance conversion circuits 20 are connected to the preceding stage and the rear stage of the equalizer 10, although the impedance conversion circuit 20 may be connected to only the preceding stage or the rear stage of the equalizer 10. Emitter followers, operational amplifiers, for example, are used as the impedance conversion circuits 20.

Since the various equalizers 10 shown in the embodiment are different from a conventional complicated circuit including serially connected filters having various characteristics and are open-loop circuits constructed very simply, the equalizers are characterized in that occurrence of the phase distortion is very small and there is no sound shift even if sound of a percussion instrument producing sound immediately and having a large dynamic range is regenerated.

When the acoustic characteristic correction circuit of the present invention is actually operated, features in the psychological aspect which can not be measured by a measuring apparatus are as follows:
(a) Since the phase distortion is small, even if sound having the same frequency and different sound quality is regenerated, the orientation feeling of the acoustic image is improved extremely as compared with the conventional method.
   More particularly, even if a violin and a piano produce sounds having the same frequency at the same time, the mutual positional relation (front or rear and right or left) of the violin and the piano is defined exactly.
(b) Sound is very clear. This is a matter of course since the phase distortion is decreased by the improved phase characteristic and the frequency characteristic is also improved. Specifically, sound produced by drawing or rubbing a string can be heard well.
(c) Sound having the presence is produced. More particularly, there is a feeling of the immediate vicinity near the speaker or player. This is considered to be the synergism by improvement of the orientation feeling. More particularly speaking of the presence, near sound source is heard to be positioned in front of a loudspeaker and far sound source is heard to be positioned at the back of the loudspeaker. Further, the azimuth angle of the sound source in the right and left direction is realized so that the sound source is wider or narrower than the azimuth angle of the loudspeaker. Thus, it is near to an image of the regeneration of original sound field rather than an image of the regeneration of original sound.
(d) It is sound which does not give fatigue even if listening to the sound for a long time. This is considered to be achieved by the fact that the phase distortion is extremely reduced so that sound is brought close to natural sound. This psychological effect is specifically important for an audio system of a car.
(e) Even when listening to music in a room of a vehicle, it feels as if listening to the sound in a large hall and there is no oppression as if a head is suppressed. This is also considered to be achieved by the fact that the orientation feeling is improved and a position of the acoustic sound is clear by the synergism of the lead of the phase and the level up in the frequency range of 12 KHz or more.
(f) By controlling volume by a volume controller, it is heard so that the whole of the acoustic image is near and far. More particularly, when the volume is decreased, it feels as if the musical performance is made far, while when the volume is increased, it feels as if the musical performance is made near.
(g) So-called vibration sound generated in a saturation of an output of an amplifier is reduced or quite removed.

As described above, in the present embodiment, there have been described the acoustic characteristic correction circuit in the high fidelity regenerative amplifier including the filters each configured by one resistor and one condenser. However, the circuit is not limited thereto and naturally it may be an equalizer constructed by a complicated circuit as far as it is an equivalent circuit to the circuit of the embodiment. It is a matter of course that the equalizer 10 of the embodiment can be applied to various amplifiers such as an audio amplifier used in a room, an audio amplifier mounted in an automobile and the like.

## Claims

1. An acoustic characteristic correction circuit in a high fidelity reproducing amplifier which corrects the sound quality and the frequency characteristic of the reproduced sound so that the reproduced sound in various environments can be reproduced in a state near to original sound,
comprising an equalizer (10) for low, medium and high frequency correction, wherein said low frequency correction has
- an amplitude frequency response characteristic which approximately is reverse to a peak of a resonance frequency of the environment wherein the sound is to be reproduced,
- and an impedance conversion circuit (20) which is connected to the preceding stage and/or the following stage of said equalizer (10);
characterized in that
- the equalizer includes resistors (R₁, R₂, R₃) and condensers (C₁, C₂, C₃) connected in parallel or series,
and that
- (1) said equalizer provides a low frequency correction having the characteristic that the phase of an input signal corresponding to an aural signal is delayed for low frequencies of the aural signal, and
- (2) said equalizer provides a medium frequency correction and a high frequency correction having
- (a) a characteristic that the phase of the input signal corresponding to an aural signal is advanced for frequencies higher than about 1 kHz, and
- (b) a circuit configuration effecting the advancement of the phase from about 1 kHz to 5 kHz approximately; and
- (3) the equalizer being further characterized by the maximum of phase delay being about 35° at about 100 to 150 Hz and the maximum phase advance being about 40° at about 2 to 3 kHz.

2. An equalizer according to claim 1, characterized in that said medium frequency correction and said high frequency correction include a characteristic that the phase of the input signal corresponding to an aural signal is advanced for frequencies from about 5 kHz to 12 kHz.

## Patentansprüche

1. Akustik-Charakteristik-Korrekturschaltung in einem Verstärker für qualitativ hochwertige Wiedergabe, welche die Klangqualität und die Frequenzcharakteristik des wiedergegebenen Klangs so korrigiert, daß der wiedergegebene Klang in verschiedenen Umgebungen in einem Zustand nahe dem ursprünglichen Klang wiedergegeben werden kann,
umfassend einen Entzerrer (10) für Niedrig-, Mittel- und Hochfrequenzkorrektur, worin die Niedrigfrequenzkorrektur
- eine Amplituden-Frequenz-Ansprechcharakteristik hat, welche angenähert umgekehrt zu einer Spitze einer Resonanzfrequenz der Umgebung ist, worin der Klang wiedergegeben werden soll,
- und eine Impedanz-Wandlungsschaltung (20) hat, welche mit der vorhergehenden Stufe und/oder der folgenden Stufe des Entzerrers (10) verbunden ist;
dadurch **gekennzeichnet**, daß
- der Entzerrer Widerstände (R₁, R₂, R₃) und Kondensatoren (C₁, C₂, C₃), die parallel oder in Reihe geschaltet sind, umfaßt,
und daß
- (1) der Entzerrer eine Niedrigfrequenzkorrektur vorsieht, welche die Charakteristik hat, daß die Phase eines Eingangssignals, welches einem Tonsignal entspricht, für niedrige Frequenzen des Tonsignals verzögert wird, und
- (2) der Entzerrer einer Mittelfrequenzkorrektur und eine Hochfrequenzkorrektur vorsieht, die
- (a) eine Charakteristik hat, daß die Phase des Eingangssignals, das einem Tonsignal entspricht, für Frequenzen, die höher als etwa 1 kHz sind, vorgerückt wird, und
- (b) eine Schaltungskonfiguration hat, welche das Vorrücken der Phase von etwa 1 kHz bis angenähert 5 kHz bewirkt; und
- (3) der Entzerrer weiter dadurch **gekennzeichnet** ist, daß das Maximum der Phasenverzögerung etwa 35° bei etwa 100 bis 150 Hz und das Maximum der Phasenvoreilung etwa 40° bei etwa 2 bis 3 kHz ist.

2. Entzerrer gemäß Anspruch 1, dadurch **gekennzeichnet**, daß die Mittelfrequenzkorrektur und die Hochfrequenzkorrektur eine Charakteristik aufweisen, daß die Phase des Eingangssignals, das einem Tonsignal entspricht, für Frequenzen von etwa 5 kHz bis 12 kHz vorgerückt wird.

## Revendications

1. Circuit de correction de caractéristique acoustique dans un amplificateur de reproduction haute fidélité, qui corrige la qualité de son et la caractéristique de fréquence du son reproduit, de sorte que le son reproduit dans divers environnements peut être reproduit dans un état proche du son original, comprenant un égaliseur (10) pour correction de basse fréquence, moyenne fréquence et haute fréquence, dans lequel la dite correction de basse fréquence comporte :
une caractéristique de réponse de fréquence en amplitude qui est approximativement l'inverse d'un pic d'une fréquence de résonance de l'environnement dans lequel le son doit être reproduit, et
un circuit de conversion d'impédance (20) qui est connecté à l'étage précédent et/ou à l'étage suivant du dit égaliseur (10) ;
caractérisé en ce que :
l'égaliseur comprend des résistances (R₁, R₂, R₃,) et des condensateurs (C₁, C₂, C₃) connectés en parallèle ou en série,
et en ce que :
(1) le dit égaliseur fournit une correction de basse fréquence ayant la caractéristique que la phase d'un signal d'entrée correspondant à un signal sonore est retardée pour les basses fréquences du signal sonore, et
(2) le dit égaliseur fournit une correction de fréquence moyenne et une correction de haute fréquence ayant
(a) une caractéristique telle que la phase du signal d'entrée correspondant à un signal sonore est avancée pour les fréquences supérieures à 1 kHz, et
(b) une configuration de circuit effectuant l'avancement de la phase, à partir de 1 kHz environ jusqu'à 5 kHz environ, et
(3) l'égaliseur est caractérisé en outre en ce que le maximum de retard de phase est de 35° environ à une fréquence de 100 à 150 Hz environ et l'avance de phase maximale est de 40° environ à une fréquence de 2 à 3 kHz environ.

2. Egaliseur suivant la revendication 1, caractérisé en ce que la dite correction de fréquence moyenne et la dite correction de haute fréquence fournissent une caractéristique telle que la phase du signal d'entrée correspondant à un signal sonore est avancée pour les fréquences comprises entre 5 kHz et 12 kHz environ.
